# DEMANDE DE BREVET EUROPEEN

(11) **EP 4 727 301 A1**
(43) Date de publication de la demande: **15.04.2026**
(21) Numéro de dépôt: 25206579.2
(22) Date de dépôt: 03.10.2025
(51) Int. Cl.: H10F 39/00

(54) **CAPTEUR D'IMAGES**

(30) Priorité: 11.10.2024 FR 2411017
(71) Demandeur: Commissariat à l'Energie Atomique et aux Energies Alternatives, 75015 Paris (FR)
(72) Inventeur: BECKER, Sébastien, 38054 GRENOBLE CEDEX 09 (FR); ALIANE, Abdelkader, 38054 GRENOBLE CEDEX 09 (FR); ABADIE, Quentin, 38054 GRENOBLE CEDEX 09 (FR)
(74) Mandataire: Cabinet Beaumont

(57) **Abrégé**

La présente description concerne un capteur d'images (100) comprenant une pluralité de pixels (PIX) formés dans et sur un substrat semiconducteur (101) et comportant chacun au moins un photodétecteur (PD) comprenant une cavité résonnante (103) comportant, entre des première (105) et deuxième (107) couches miroir, une couche de photoconversion (109) et au moins une structure diffractive (111).

## Description

### Domaine technique

La présente description concerne de façon générale les dispositifs électroniques, plus particulièrement les capteurs d'images comprenant des photodétecteurs à cavité résonnante.

### Technique antérieure

Des capteurs d'images comprenant des photodétecteurs à cavité résonnante (« Resonant-Cavity-Enhanced » - RCE, en anglais) ont été proposés. Des exemples de tels capteurs, qui permettent d'accéder à une très bonne sélectivité spectrale, sont par exemple détaillés dans la revue MDPI de Jinzhao Li et al. intitulée « Metasurface Photodetectors ». Cette revue décrit des capteurs d'images comprenant des photodétecteurs à cavités optiques résonnantes d'épaisseurs différentes. Le contrôle de l'épaisseur de chaque cavité est, dans ce cas, réalisé par une lithographie de type « grayscale » (à niveaux de gris). Le capteur d'images ainsi obtenu présente toutefois un nombre de voies spectrales limité par une résolution en épaisseur accessible par la lithographie grayscale. Par ailleurs, la revue susmentionnée indique que d'autres types de photodétecteurs à cavité optique résonnante ont été proposés pour réaliser une fonction multispectrale. Toutefois, l'ensemble des propositions décrites aboutissent à des solutions technologiquement complexes à réaliser car elles comprennent notamment des structures suspendues au-dessus de cavités d'air.

### Résumé de l'invention

Un objet d'un mode de réalisation est de pallier tout ou partie des inconvénients des capteurs d'images connus et de leurs procédés de fabrication. Un mode de réalisation vise en particulier à pallier tout ou partie des inconvénients des capteurs d'images existants comprenant des photodétecteurs à cavité optique résonnante et des procédés de fabrication de tels capteurs.

Pour cela, un mode de réalisation prévoit un capteur d'images comprenant une pluralité de pixels formés dans et sur un substrat semiconducteur et comportant chacun au moins un photodétecteur comprenant une cavité résonnante comportant, entre des première et deuxième couches miroir, une couche de photoconversion et au moins une structure diffractive.

Selon un mode de réalisation, chaque structure diffractive comprend une pluralité de premières régions en un premier matériau présentant un premier indice de réfraction séparées les unes des autres par au moins une deuxième région en un deuxième matériau présentant un deuxième indice de réfraction inférieur au premier indice de réfraction.

Selon un mode de réalisation, les premier et deuxième matériaux présentent une même composition chimique et des structures différentes.

Selon un mode de réalisation, les structures diffractives des cavités résonnantes des photodétecteurs présentent un même facteur de remplissage.

Selon un mode de réalisation, la au moins une structure diffractive de la cavité résonnante de l'un des photodétecteurs présente un facteur de remplissage différent de celui de la au moins une structure diffractive de la cavité résonnante d'un autre photodétecteur.

Selon un mode de réalisation, les premières régions de la au moins une structure diffractive de la cavité résonnante de l'un des photodétecteurs forment un réseau présentant un pas différent de celui d'un réseau formé par les premières régions de la au moins une structure diffractive de la cavité résonnante d'un autre photodétecteur.

Selon un mode de réalisation, les premières régions de la au moins une structure diffractive de la cavité résonnante de l'un des photodétecteurs présentent des dimensions latérales différentes de celles des premières régions de la au moins une structure diffractive de la cavité résonnante d'un autre photodétecteur.

Selon un mode de réalisation, à l'intérieur d'une même structure diffractive, l'une des premières régions présente des dimensions latérales différentes de celles d'une autre première région.

Selon un mode de réalisation, chaque première région est un plot.

Selon un mode de réalisation, chaque première région est une bande s'étendant latéralement entre deux flancs opposés de la structure diffractive.

Selon un mode de réalisation, les premières régions forment une grille et les deuxièmes régions forment des plots situés dans des cases de la grille.

Selon un mode de réalisation, au moins l'une des cavités résonnantes présente une épaisseur différente de celle d'une autre cavité résonnante.

Selon un mode de réalisation, la cavité résonnante est constituée d'un empilement comprenant, dans l'ordre depuis une face supérieure du substrat semiconducteur, la première couche miroir, la couche de photoconversion, la structure diffractive et la deuxième couche miroir.

Selon un mode de réalisation, chaque cavité résonnante comprend en outre au moins une première couche isolante interposée entre la au moins une structure diffractive et la deuxième couche miroir.

Selon un mode de réalisation, chaque cavité résonnante comprend en outre au moins une deuxième couche isolante interposée entre la couche de photoconversion et la au moins une structure diffractive.

Selon un mode de réalisation, le au moins un photodétecteur est un photodétecteur infrarouge, de préférence un photodétecteur infrarouge proche.

Selon un mode de réalisation, chaque pixel comprend en outre, superposé audit au moins un photodétecteur, un photodétecteur visible.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue de côté et en coupe, schématique et partielle, d'un exemple de capteur d'images selon un mode de réalisation ;
la figure 2 est une vue de côté et en coupe, schématique et partielle, d'un exemple de capteur d'images selon un mode de réalisation ;
la figure 3 est une vue de côté et en coupe, schématique et partielle, d'un exemple de capteur d'images selon un mode de réalisation ;
la figure 4 est une vue de côté et en coupe, schématique et partielle, d'un exemple de capteur d'images selon un mode de réalisation ;
la figure 5 est une vue de côté et en coupe, schématique et partielle, d'un exemple de capteur d'images selon un mode de réalisation ;
la figure 6 est une vue de côté et en coupe, schématique et partielle, d'un exemple de capteur d'images selon un mode de réalisation ;
la figure 7 est une vue de côté et en coupe, schématique et partielle, d'un exemple de capteur d'images selon un mode de réalisation ;
la figure 8 est une vue de côté et en coupe, schématique et partielle, d'un exemple de capteur d'images selon un mode de réalisation ;
la figure 9 est une vue de côté et en coupe, schématique et partielle, d'un exemple de capteur d'images selon un mode de réalisation ; et
la figure 10A, la figure 10B, la figure 10C, la figure 10D et la figure 10E illustrent, par des vues de côté et en coupe, schématiques et partielles, des structures obtenues à l'issue d'étapes successives d'un procédé de fabrication d'un exemple de capteur d'images selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les circuits de commande des pixels des capteurs d'images n'ont pas été détaillés, la réalisation de ces circuits étant à la portée de la personne du métier à partir des indications de la présente description. Par ailleurs, les applications des capteurs d'images comprenant des photodétecteurs à cavité optique résonnante n'ont pas été détaillées, les modes de réalisation décrits étant compatibles avec toutes ou la plupart des applications de tels capteurs d'images, moyennant éventuellement des adaptations à la portée de la personne du métier à la lecture de la présente description. À titre d'exemple, les capteurs d'images de la présente description peuvent être mis en œuvre dans des applications d'imagerie 3D, de biosurveillance (« biomonitoring », en anglais) - par exemple des applications visant à effectuer des mesures optiques de glycémie - et dans des applications utilisant un détecteur de lumière ambiante (« Ambient Light Sensor » - ALS, en anglais) - par exemple des applications d'ajustement de balance des blancs (« White Balance » - WB, en anglais).

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % ou à 10° près, de préférence à 5 % ou à 5° près.

Dans la description qui suit, les qualificatifs « isolant » et « conducteur » signifient respectivement, sauf précision contraire, électriquement isolant et électriquement conducteur.

Sauf précision contraire, l'expression « en contact avec » signifie « en contact mécanique avec ».

L'expression « lumière visible » désigne un rayonnement électromagnétique dont la longueur d'onde est comprise entre 400 nm et 800 nm. L'expression « rayonnement infrarouge » désigne un rayonnement électromagnétique dont la longueur d'onde est comprise entre 800 nm et 1 mm. Dans le domaine infrarouge, le rayonnement infrarouge proche (Short-Wave Infrared - SWIR, en anglais) présente une longueur d'onde comprise entre 800 nm et 1,7 µm.

L'expression « transmittance d'une couche » désigne un rapport entre une intensité d'un rayonnement sortant de la couche et une intensité du rayonnement entrant dans la couche. Dans la suite de la description, une couche est dite opaque à un rayonnement lorsque sa transmittance est, pour ce rayonnement, strictement inférieure à 40 %, de préférence inférieure ou égale à 25 %, plus préférentiellement inférieure ou égale à 10 %. Par ailleurs, une couche est dite transparente à un rayonnement lorsque sa transmittance est, pour ce rayonnement, supérieure ou égale à 40 %, de préférence supérieure ou égale à 75 %, plus préférentiellement supérieure ou égale à 90 %. La définition des qualificatifs opaque et transparent(e) qui précède n'est pas limitée au cas d'une couche, mais s'applique plus généralement à tout élément susceptible d'être exposé à un rayonnement, par exemple un substrat, une région, un empilement de plusieurs couches, etc.

L'expression « rayonnement d'intérêt » désigne un rayonnement présentant une longueur d'onde correspondant sensiblement à un pic d'absorption maximale d'un élément photosensible, par exemple un photodétecteur d'un pixel de capteur d'images.

L'expression « couche de photoconversion » d'un composant optoélectronique, notamment d'un photodétecteur, désigne une couche dans laquelle est absorbée la majorité du rayonnement électromagnétique reçu par le composant optoélectronique et dans laquelle ce rayonnement est converti en charges électriques.

L'indice de réfraction d'un matériau correspond à l'indice de réfraction du matériau pour la plage de longueurs d'onde du rayonnement capté par le capteur d'images. Sauf indication contraire, l'indice de réfraction est considéré sensiblement constant sur la plage de longueurs d'onde du rayonnement utile, par exemple égal à la moyenne de l'indice de réfraction sur la plage de longueurs d'onde du rayonnement d'intérêt capté par le capteur d'images.

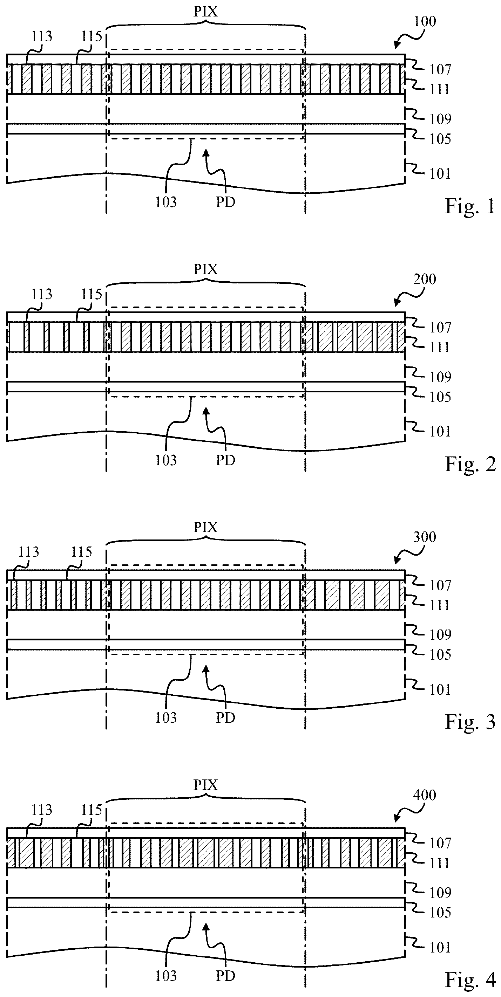

La figure 1 est une vue de côté et en coupe, schématique et partielle, d'un exemple de capteur d'images 100 selon un mode de réalisation.

Dans l'exemple illustré, le capteur d'images 100 est destiné à être illuminé ou éclairé, depuis sa face supérieure, par un rayonnement électromagnétique comprenant au moins un rayonnement parmi de la lumière visible et un rayonnement infrarouge, par exemple un rayonnement infrarouge proche.

Dans l'exemple représenté, le capteur d'images 100 comprend une pluralité de pixels PIX formés dans et sur un substrat semiconducteur 101, par exemple une plaquette ou un morceau de plaquette en un matériau semiconducteur, par exemple le silicium. Les pixels PIX sont par exemple agencés en matrice selon des lignes et des colonnes. Chaque pixel PIX présente par exemple, en vue de dessus, une forme carrée. Cet exemple n'est toutefois pas limitatif, chaque pixel PIX pouvant plus généralement présenter, en vue de dessus, une forme quelconque, par exemple une forme polygonale autre que carrée - par exemple rectangulaire, triangulaire, hexagonale, etc. - ou une forme arrondie - par exemple ovale, circulaire, etc. Bien que cela n'ait pas été détaillé en figure 1, des circuits de commande et de lecture des pixels PIX du capteur d'images 100 sont par exemple formés dans et sur le substrat semiconducteur 101. Par ailleurs, bien que seuls trois pixels PIX aient été représentés en figure 1, le capteur d'images 100 peut bien entendu comporter un nombre de pixels PIX beaucoup plus important, par exemple plusieurs milliers ou plusieurs millions de pixels PIX.

Selon un mode de réalisation, chaque pixel PIX du capteur d'images 100 comporte un photodétecteur PD comprenant une cavité résonnante 103 comportant, entre des première et deuxième couches miroir 105 et 107, une couche de photoconversion 109 et au moins une structure diffractive 111. À des fins de simplification, la description qui suit détaille un cas dans lequel chaque pixel PIX du capteur d'images 100 comprend un seul photodétecteur PD. Cet exemple n'est toutefois pas limitatif et chaque pixel PIX du capteur d'images 100 peut, à titre de variante, comprendre un nombre quelconque, supérieur ou égal à deux, de photodétecteurs PD. La variante de réalisation dans laquelle chaque pixel PIX du capteur d'images 100 comporte au moins deux photodétecteurs PD est à la portée de la personne du métier à partir de la présente description.

À titre d'exemple, les cavités résonnantes 103 du capteur d'images 100 sont des cavités de type Fabry-Perot.

Dans l'exemple illustré, la première couche miroir 105, ou première couche optiquement réfléchissante, revêt la face supérieure du substrat semiconducteur 101. Dans cet exemple, la première couche miroir 105 est plus précisément située sur et en contact avec la face supérieure du substrat semiconducteur 101. La première couche miroir 105 présente par exemple une structure monocouche. Dans ce cas, la première couche miroir 105 est par exemple une couche métallique, c'est-à-dire une couche en un métal ou en un alliage métallique, ou une couche en un matériau semiconducteur fortement dopé, par exemple du silicium dopé. À titre de variante, la première couche miroir 105 peut présenter une structure multicouche. Dans ce cas, la première couche miroir 105 est par exemple un miroir de Bragg constitué d'un empilement de couches d'indices de réfraction alternés.

Dans l'exemple représenté, la couche de photoconversion 109, aussi appelée couche photosensible ou couche active, revêt la face supérieure de la première couche miroir 105. Dans cet exemple, la couche de photoconversion 109 est située sur et en contact avec la face supérieure de la première couche miroir 105. La couche de photoconversion 109 est par exemple une couche optiquement absorbante destinée à absorber, ou à capter, le rayonnement illuminant le capteur d'images 100 et à convertir des photons de ce rayonnement en paires électron-trou. La couche de photoconversion 109 est par exemple une couche semiconductrice inorganique, par exemple en silicium dans un cas où le capteur d'images 100 est un capteur visible ou infrarouge proche. Cet exemple n'est toutefois pas limitatif et la couche de photoconversion 109 peut, à titre de variante, être en au moins un matériau semiconducteur de la famille IV, par exemple en germanium, en silicium-germanium, en germanium-étain, etc. Par ailleurs, la couche de photoconversion 109 peut intégrer un super-réseau, des boîtes quantiques (« quantum dots », en anglais), par exemple à base de sulfure de plomb ou d'arséniure d'indium, de matériaux semiconducteur III-V, par exemple l'InGaAs et ses dérivés, de matériaux semiconducteurs II-VI, par exemple le HgCdTe, etc. Il peut également s'agir de couches de matériaux organiques comme le PEDOT:PSS ou un matériau de la famille des pérovskites. À titre d'exemple, la couche de photoconversion 109 présente une épaisseur comprise globalement entre λ/6 et λ/4, où λ est la longueur d'onde du rayonnement incident. Dans le cas de l'infrarouge proche, cela correspond à une épaisseur comprise entre 200 et 400 nm, par exemple égale à environ 250 nm.

Dans l'exemple illustré, la structure diffractive 111 revêt la face supérieure de la couche de photoconversion 109. Dans cet exemple, la structure diffractive 111 est plus précisément située sur et en contact avec la face supérieure de la couche de photoconversion 109.

De manière générale, la structure diffractive 111 comprend une pluralité de premières régions 113 en un premier matériau présentant un premier indice de réfraction n1, les premières régions 113 étant disjointes et séparées latéralement les unes des autres par au moins une deuxième région 115 en un deuxième matériau présentant un deuxième indice de réfraction n2, différent du premier indice de réfraction n1. Les premières régions 113 présentent au moins une dimension latérale strictement inférieure à une longueur d'onde d'un rayonnement d'intérêt destiné à illuminer le capteur d'images 100. À titre d'exemple, les premier et deuxième matériaux présentent des compositions chimiques différentes. À titre de variante, les premier et deuxième matériaux peuvent présenter des compositions chimiques identiques et différer par leur structure, l'un des matériaux correspondant par exemple à une phase amorphe d'un matériau à changement de phase, par exemple un matériau chalcogénure tel que le GST, le Sb₂S₃, le Sb₂Se₃, etc., l'autre matériau correspondant alors à la phase cristalline de ce matériau.

Les premier et deuxième matériaux sont par exemple choisis de sorte qu'ils présentent un contraste d'indice de réfraction le plus grand possible ou, dit autrement, de sorte que la différence entre les premier et deuxième indices de réfraction n1 et n2 soit la plus grande possible. Le premier indice de réfraction n1 est par exemple strictement supérieur au deuxième indice de réfraction n2. Par ailleurs, les premier et deuxième matériaux présentent par exemple, à la longueur d'onde du rayonnement d'intérêt, un coefficient d'extinction sensiblement nul. À titre d'exemple, chaque première région 113 est en silicium et chaque deuxième région 115 est en oxyde de silicium. Dans le cas d'une détection dans le visible, chaque première région 113 peut, à titre de variante, être en un oxyde métallique tel que le HfO₂, le Nb₂O₅ ou le TiO₂. Il peut aussi s'agir par exemple de GaP ou de tout autre matériau présentant un fort indice de réfraction et un faible coefficient d'extinction pour la bande spectrale d'intérêt. Cet exemple n'est toutefois pas limitatif et chaque deuxième région 115 peut, à titre de variante, être constituée d'une cavité remplie d'air ou d'une cavité dans laquelle règne un vide partiel.

Dans l'exemple représenté, les premières régions 113 présentent une même hauteur, ou épaisseur, c'est-à-dire une même dimension selon une direction orthogonale aux première et deuxième couches miroir 105 et 107. Dans cet exemple, les deuxièmes régions 115 présentent en outre une même hauteur, ou épaisseur, par exemple une hauteur sensiblement égale à celle des premières régions 113.

Chaque première région 113 est par exemple un plot. Dans ce cas, la structure diffractive 111 comprend par exemple une seule deuxième région 115 revêtant les parois latérales, ou flancs, des premières régions 113. À titre d'exemple, la deuxième région 115 comble, c'est-à-dire remplit totalement, tous les espaces libres s'étendant latéralement entre les premières régions 113. Dans cet exemple, la deuxième région 115 est située sur et en contact avec toutes les parois latérales des premières régions 113. Chaque plot présente par exemple, en vue de dessus, une section de forme rectangulaire ou carrée. Cet exemple n'est toutefois pas limitatif, chaque plot pouvant plus généralement présenter, en vue de dessus, une section de forme quelconque, par exemple une section de forme polygonale autre que carrée ou rectangulaire - par exemple triangulaire, hexagonale, etc. - ou une section de forme arrondie - par exemple ovale, circulaire, etc. Dans le cas où chaque première région 113 est un plot de section rectangulaire, carrée ou circulaire, la largeur, le côté ou le diamètre, respectivement, du plot est par exemple strictement inférieur(e) à la longueur d'onde du rayonnement d'intérêt, par exemple au moins deux à dix fois inférieur(e) à la longueur d'onde du rayonnement d'intérêt.

À titre de variante, chaque première région 113 peut présenter la forme d'une bande s'étendant latéralement le long d'une direction parallèle à la face supérieure de la couche de photoconversion 109, par exemple une direction sensiblement orthogonale au plan de coupe de la figure 1, entre deux flancs opposés de la structure diffractive 111. Chaque bande présente par exemple, en vue de dessus, une forme rectangulaire. Dans cette variante, la structure diffractive comprend par exemple plusieurs deuxièmes régions 115, chaque deuxième région 115 étant alors interposée latéralement entre deux premières régions 113 voisines. À titre d'exemple, chaque deuxième 115 région comble, c'est-à-dire remplit totalement, tous les espaces libres s'étendant latéralement entre deux premières régions 113 voisines. Dans cet exemple, chaque deuxième région 115 est située sur et en contact avec les parois latérales des premières régions 113 voisines situées en vis-à-vis. Dans le cas où chaque première région 113 est une bande de forme rectangulaire, la largeur de chaque bande est par exemple strictement inférieure à la longueur d'onde du rayonnement d'intérêt.

À titre de variante, les premières régions 113 peuvent former une grille, chaque deuxième région 115 étant alors en forme de plot situé dans une des cases de la grille. À titre de variante, les première et deuxième régions 113 et 115 peuvent présenter une forme « libre » (« free-form », en anglais), c'est-à-dire que les régions 113 et 115 ne présentent dans ce cas aucune forme et/ou aucune dimension et/ou aucune symétrie définie et répétable d'un pixel PIX à l'autre.

Chaque première région 113 correspond par exemple à un élément unitaire de la structure diffractive 111. La structure diffractive 111 est par exemple une méta-surface. Chaque première région 113 correspond par exemple à un méta-atome de la méta-surface.

À titre d'exemple, la structure diffractive peut être réalisée de sorte à former un réseau de diffraction à guide d'onde résonnant (« Resonant Waveguide Grating » - RWG, en anglais), ou filtre résonnant à mode guidé.

La structure diffractive 111 peut présenter une fréquence de résonance qui dépend de plusieurs paramètres parmi lesquels : les dimensions latérales des premières régions 113, les indices de réfraction n1 et n2 des premières et deuxième(s) régions 113 et 115, et la répartition spatiale des premières et deuxième(s) régions 113 et 115. En modifiant ces paramètres, il est donc possible de contrôler la fréquence de résonance de la structure diffractive 111, par exemple de sorte que la fréquence de résonance corresponde à une longueur d'onde que l'on souhaite capter au moyen des photodétecteurs PD. Par rapport à l'utilisation de filtres colorés ou à l'utilisation de cavités analogues aux cavités 103 mais dépourvues de la structure diffractive 111, l'utilisation de la structure diffractive 111 permet d'obtenir une meilleure sélectivité en termes de longueurs d'onde.

Dans l'exemple illustré, la deuxième couche miroir 107, ou deuxième couche optiquement réfléchissante, revêt la face supérieure de la structure diffractive 111. Dans cet exemple, la deuxième couche miroir 107 est plus précisément située sur et en contact avec la face supérieure de la structure diffractive 111. La deuxième couche miroir 107 est par exemple analogue ou identique à la première couche miroir 105.

Chaque photodétecteur PD comprend ainsi un empilement vertical comportant, dans l'ordre depuis la face supérieure du substrat 101, la première couche miroir 105, la couche de photoconversion 109, la structure diffractive 111 et la deuxième couche miroir 107. Dans l'exemple illustré en figure 1, l'empilement est plus précisément constitué, dans l'ordre depuis la face supérieure du substrat 101, de la première couche miroir 105, de la couche de photoconversion 109, de la structure diffractive 111 et de la deuxième couche miroir 107.

Les première et deuxième couches miroir 105 et 107 sont destinées à confiner, dans la cavité résonnante 103, le rayonnement incident illuminant le capteur d'images 100. Lorsque ce rayonnement parvient sur la face supérieure du capteur d'images 100, il traverse la deuxième couche miroir 107, la structure diffractive 111 et la couche de photoconversion 109. En traversant la couche de photoconversion 109, certains photons du rayonnement sont absorbés et convertis en paires électron-trou. Les photons résiduels, c'est-à-dire les photons n'ayant pas été absorbés par la couche de photoconversion 109, parviennent jusqu'à la face supérieure de la première couche miroir 105 et sont alors réfléchis ou renvoyés, vers le haut, en direction de la deuxième couche miroir 107. Certains photons sont là encore absorbés et convertis en paires électron-trou par la couche de photoconversion 109, tandis que les autres photons traversent la couche de photoconversion 109 et la structure diffractive 111. Ces photons parviennent jusqu'à la face inférieure de la deuxième couche miroir 107 qui les réfléchit ou les renvoie, vers le bas, en direction de la première couche miroir 105.

Les photons présentant une longueur d'onde compatible avec, ou sélectionnée par, la cavité résonnante 103 peuvent ainsi effectuer plusieurs allers-retours à l'intérieur de la cavité résonnante 103 avant d'être absorbés par la couche de photoconversion 109, ce qui permet d'améliorer le rendement d'absorption pour cette longueur d'onde. La couche de photoconversion 109 absorbe majoritairement les photons du rayonnement présentant une longueur d'onde correspondant sensiblement à la fréquence de résonance de la cavité résonnante associée à la structure diffractive 111. Cela permet aux photodétecteurs PD des pixels PIX du capteur d'images 100 de la figure 1 de présenter un rendement ou taux de photoconversion supérieur à celui de photodétecteurs PD analogues mais dépourvus des cavités optiquement résonnantes 103 ou de prévoir, pour un même taux de photoconversion, une couche de photoconversion 109 de plus faible épaisseur.

La figure 1 illustre un mode de réalisation dans lequel les premières régions 113 des structures diffractives 111 de tous les photodétecteurs PD du capteur d'images 100 présentent des dimensions latérales sensiblement identiques. En outre, dans ce mode de réalisation, les premières régions 113 forment un réseau présentant un pas sensiblement constant. Dans le cas où chaque première région 113 est un plot, le pas du réseau correspond par exemple à une distance centre-à-centre entre deux plots voisins. Dans le cas où chaque première région 113 est une bande, le pas du réseau correspond par exemple à une distance entre deux lignes médianes de deux bandes voisines. Plus précisément, dans ce cas, les premières régions 113 présentent, à l'intérieur de la structure diffractive 111 d'un même pixel PIX, des dimensions latérales identiques et un pas sensiblement constant. Par ailleurs, dans le mode de réalisation de la figure 1, les premières régions 113 de la structure diffractive 111 de chaque photodétecteur PD présentent des dimensions latérales et un pas sensiblement identiques aux dimensions latérales et au pas des premières régions 113 des structures diffractives 111 des autres photodétecteurs PD du capteur d'images 100.

Les structures diffractives 111 peuvent permettre au capteur d'images 100 de présenter une meilleure tolérance angulaire qu'un capteur d'images dépourvu des structures diffractives 111.

Bien que cela n'ait pas été représenté en figure 1 afin de ne pas surcharger le dessin, une tranchée d'isolation périphérique peut être formée autour de la cavité résonnante 103 de chaque photodétecteur PD du capteur d'images 100. Dans ce cas, la tranchée s'étend par exemple verticalement, depuis la face supérieure de la cavité résonnante 103, sur tout ou partie de la hauteur de la cavité résonnante 103 du photodétecteur PD. À titre d'exemple, la tranchée d'isolation peut comprendre une région centrale en un matériau conducteur, par exemple un métal, un alliage métallique ou un matériau semiconducteur dopé, entourée d'une région périphérique isolante, par exemple en un oxyde. À titre de variante, la région centrale est en un matériau présentant un indice de réfraction faible, par exemple strictement inférieur à celui de la couche de photoconversion 109.

La figure 2 est une vue de côté et en coupe, schématique et partielle, d'un exemple de capteur d'images 200 selon un mode de réalisation.

Le capteur d'images 200 de la figure 2 comprend des éléments en commun avec le capteur d'images 100 de la figure 1. Ces éléments communs ne seront pas détaillés à nouveau ci-après.

Le capteur d'images 200 de la figure 2 diffère du capteur d'images 100 de la figure 1 en ce que les structures diffractives 111 des photodétecteurs PD des pixels PIX du capteur d'images 200 de la figure 2 présentent des facteurs de remplissage différents. Le facteur de remplissage de chaque structure diffractive 111 correspond au rapport entre, d'une part, la surface cumulée, en vue de dessus, des premières régions 113, et, d'autre part, la surface de la deuxième région 115 ou la surface cumulée des deuxièmes régions 115, en vue de dessus, de la structure diffractive 111.

Dans l'exemple illustré, les premières régions 113 des structures diffractives 111 forment un réseau présentant un pas sensiblement constant sur l'ensemble du capteur d'images 200. Dans cet exemple, les premières régions 113 de la structure diffractive 111 de l'un des photodétecteurs PD (par exemple la structure diffractive 111 du photodétecteur PD du pixel PIX central, dans l'orientation de la figure 2) présentent des dimensions latérales différentes de celles des premières régions 113 de la structure diffractive 111 de l'un des autres photodétecteurs PD du capteur d'images 200 (par exemple la structure diffractive 111 du photodétecteur PD du pixel PIX de gauche, dans l'orientation de la figure 2).

La plage de longueurs d'onde absorbée par chaque cavité résonnante 103 est fonction, outre d'une épaisseur de la cavité 103, du facteur de remplissage de la structure diffractive 111 . Dans un cas où la structure diffractive est périodique et symétrique, plus le facteur de remplissage de la structure diffractive 111 est élevé, plus la longueur d'onde du rayonnement majoritairement absorbé par le pixel PIX correspondant est élevée, à pas de réseau constant. Toutefois, en pratique, la structure diffractive 111 peut ne pas être périodique et/ou symétrique, par exemple du fait que l'optimisation de cette structure prend en compte d'autres paramètres que la longueur d'onde d'intérêt tels que la tolérance angulaire à l'angle d'incidence, la diaphotie entre les pixels, la position du pixel par rapport à la matrice, etc. Chaque cavité résonnante 103 présente un indice optique effectif dépendant du matériau des premières régions 113, ce matériau étant par exemple identique pour toutes les cavités 103 du capteur d'images 200, du facteur de remplissage, du pas de la structure diffractive 111 et, au second ordre, de la géométrie des régions 113 et 115 de la structure diffractive 111 de la cavité résonnante 103 considérée. En première approximation, le fait de prévoir des cavités résonnantes 103 dont les structures diffractives 111 présentent des facteurs de remplissage différents permet d'obtenir des indices optiques différents à l'intérieur de ces cavités, donc d'absorber le rayonnement incident dans des plages de longueurs d'ondes différentes.

Par ailleurs, le fait de prévoir, comme dans l'exemple illustré en figure 2, des groupes de cavités résonnantes 103 adjacentes de même épaisseur mais dont les structures diffractives présentent, à l'intérieur d'un même groupe, des facteurs de remplissage différents permet au capteur d'images 200 de bénéficier d'une résolution spatiale supérieure à celle que présenterait par exemple le capteur d'images 200 dépourvu des structures diffractives 111.

À titre d'exemple, le capteur d'images 200 est un capteur multispectral.

La figure 3 est une vue de côté et en coupe, schématique et partielle, d'un exemple de capteur d'images 300 selon un mode de réalisation.

Le capteur d'images 300 de la figure 3 comprend des éléments en commun avec le capteur d'images 100 de la figure 1. Ces éléments communs ne seront pas détaillés à nouveau ci-après.

Le capteur d'images 300 de la figure 3 diffère du capteur d'images 100 de la figure 1 en ce que les structures diffractives 111 des photodétecteurs PD des pixels PIX du capteur d'images 300 de la figure 3 présentent des facteurs de remplissage différents. Dans l'exemple illustré, les premières régions 113 des structures diffractives 111 présentent des dimensions latérales différentes d'un photodétecteur PD à l'autre et un espacement sensiblement constant. Dans cet exemple, les premières régions 113 de la structure diffractive 111 de l'un des photodétecteurs PD (par exemple la structure diffractive 111 du photodétecteur PD du pixel PIX central, dans l'orientation de la figure 3) présentent des dimensions latérales différentes de celles des premières régions 113 de la structure diffractive 111 de l'un des autres photodétecteurs PD du capteur d'images 300 (par exemple la structure diffractive 111 du photodétecteur PD du pixel PIX de gauche, dans l'orientation de la figure 3).

La figure 2 illustre un cas dans lequel des facteurs de remplissage des structures diffractives 111 différents sont obtenus en modifiant les dimensions latérales des premières régions 113 sans modifier le pas du réseau formé par les premières régions 113. En outre, la figure 3 illustre un cas dans lequel des facteurs de remplissage des structures diffractives 111 différents sont obtenus en modifiant les dimensions latérales des premières régions 113 et en modifiant le pas du réseau formé par les premières régions 113. Ces exemples ne sont toutefois pas limitatifs et la personne du métier est capable, à titre de variante, de prévoir d'autres moyens permettant d'obtenir des facteurs de remplissage des structures diffractives 111 différents, par exemple en modifiant le pas du réseau formé par les premières régions 113 sans modifier les dimensions latérales des premières régions 113. D'autres moyens permettant de modifier la longueur d'onde de résonance ont par ailleurs été décrits ci-dessus.

La figure 4 est une vue de côté et en coupe, schématique et partielle, d'un exemple de capteur d'images 400 selon un mode de réalisation.

Le capteur d'images 400 de la figure 4 comprend des éléments en commun avec le capteur d'images 100 de la figure 1. Ces éléments communs ne seront pas détaillés à nouveau ci-après.

Le capteur d'images 400 de la figure 4 diffère du capteur d'images 100 de la figure 1 en ce que les premières régions 113 des structures diffractives 111 des photodétecteurs PD des pixels PIX du capteur d'images 400 de la figure 4 présentent, à l'intérieur d'une même structure diffractive 111, des dimensions latérales différentes. Dans l'exemple représenté, les premières régions 113 faisant partie d'une même structure diffractive 111 d'un même pixel PIX forment un réseau présentant un pas sensiblement constant. Par ailleurs, dans cet exemple, les premières régions 113 des structures diffractives 111 des photodétecteurs PD de tous les pixels PIX du capteur d'images 400 forment un réseau présentant un pas sensiblement constant. Cet exemple n'est toutefois pas limitatif et la personne du métier peut, à titre de variante ou de complément, prévoir que les premières régions 113 de la structure diffractive 111 du photodétecteur PD d'au moins l'un des pixels PIX du capteur d'images 400 forment un réseau présentant un pas différent de celui formé par les premières régions 113 de la structure diffractive 111 du photodétecteur PD de l'un des autres pixels PIX du capteur d'images 400.

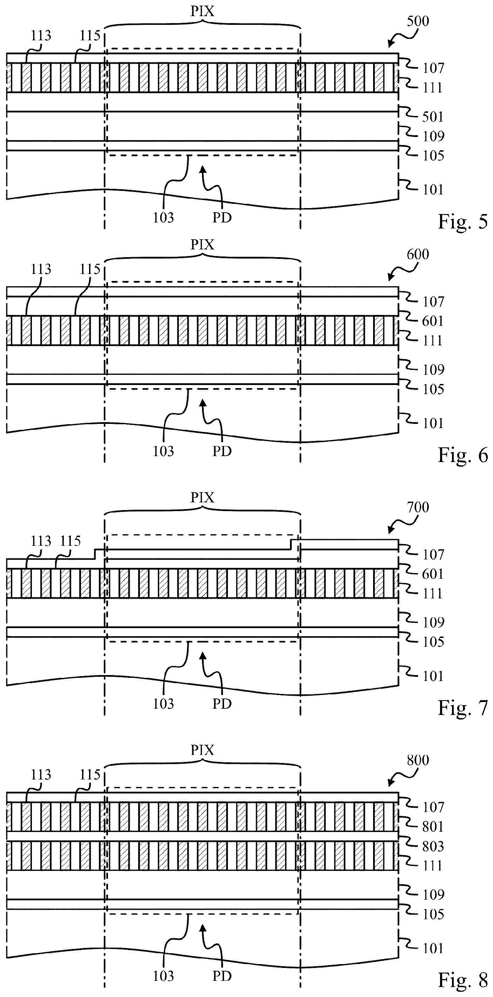

La figure 5 est une vue de côté et en coupe, schématique et partielle, d'un exemple de capteur d'images 500 selon un mode de réalisation.

Le capteur d'images 500 de la figure 5 comprend des éléments en commun avec le capteur d'images 100 de la figure 1. Ces éléments communs ne seront pas détaillés à nouveau ci-après.

Le capteur d'images 500 de la figure 5 diffère du capteur d'images 100 de la figure 1 en ce que chaque cavité résonnante 103 du capteur d'images 500 de la figure 5 comprend en outre une couche isolante 501 interposée entre la couche de photoconversion 109 et la structure diffractive 111. Dans l'exemple représenté, la couche isolante 501 est située sur et en contact, par sa face inférieure, avec la face supérieure de la couche de photoconversion 109. En outre, dans cet exemple, la couche isolante 501 est située sous et en contact, par sa face supérieure, avec la face inférieure de la structure diffractive 111. Dans l'exemple illustré, la couche isolante 501 présente une épaisseur sensiblement constante. La couche isolante 501 est une couche transparente au rayonnement d'intérêt du capteur d'images 500. À titre d'exemple, la couche isolante 501 est en un oxyde, par exemple l'oxyde de silicium. La couche isolante 501 peut présenter une structure monocouche ou multicouche, par exemple une structure comprenant plusieurs couches, par exemple deux couches, en des matériaux transparents d'indices optiques différents et présentant un fort contraste d'indices optiques, c'est-à-dire une grande différence d'indices optiques.

À titre d'exemple, la couche isolante 501 sert de guide d'ondes, par exemple dans le cas où la structure diffractive 111 forme un filtre résonnant à mode guidé. Dans ce cas, une ou plusieurs couches présentant des indices optiques et des épaisseurs couplées optiquement à la structure diffractive 111 afin de guider la lumière et induire des résonances peuvent plus généralement être prévues. Par ailleurs, la présence de la couche isolante 501 augmente le trajet optique de la lumière dans la cavité, ce qui constitue un autre moyen d'adapter la longueur d'onde de résonance du filtre.

La figure 6 est une vue de côté et en coupe, schématique et partielle, d'un exemple de capteur d'images 600 selon un mode de réalisation.

Le capteur d'images 600 de la figure 6 comprend des éléments en commun avec le capteur d'images 100 de la figure 1. Ces éléments communs ne seront pas détaillés à nouveau ci-après.

Le capteur d'images 600 de la figure 6 diffère du capteur d'images 100 de la figure 1 en ce que chaque cavité résonnante 103 du capteur d'images de la figure 6 comprend en outre une couche isolante 601 interposée entre la structure diffractive 111 et la deuxième couche miroir 107. Dans l'exemple représenté, la couche isolante 601 est située sur et en contact, par sa face inférieure, avec la face supérieure de la structure diffractive 111. En outre, dans cet exemple, la couche isolante 601 est située sous et en contact, par sa face supérieure, avec la face inférieure de la deuxième couche miroir 107. Dans l'exemple illustré, la couche isolante 601 présente une épaisseur sensiblement constante. La couche isolante 601 est une couche transparente au rayonnement d'intérêt du capteur d'images 600. À titre d'exemple, la couche isolante 601 est en un oxyde, par exemple l'oxyde de silicium. La couche isolante 601 peut présenter une structure monocouche ou multicouche, par exemple une structure comprenant plusieurs couches, par exemple deux couches, en des matériaux transparents d'indices optiques différents et présentant un fort contraste d'indices optiques.

La couche isolante 601 est par exemple analogue à la couche isolante 501.

La figure 7 est une vue de côté et en coupe, schématique et partielle, d'un exemple de capteur d'images 700 selon un mode de réalisation.

Le capteur d'images 700 de la figure 7 comprend des éléments en commun avec le capteur d'images 600 de la figure 6. Ces éléments communs ne seront pas détaillés à nouveau ci-après.

Le capteur d'images 700 de la figure 7 diffère du capteur d'images 600 de la figure 6 en ce que la couche isolante 601 du capteur d'images 700, interposée entre la structure diffractive 111 et la deuxième couche miroir 107, présente une épaisseur variable. Dans l'exemple représenté, la couche isolante 601 de la cavité résonnante 103 du photodétecteur PD de l'un des pixels PIX du capteur d'images 700 (par exemple la couche isolante 601 de la cavité 103 du pixel PIX central, dans l'orientation de la figure 7) présente une épaisseur différente de celle de la couche isolante 601 de la cavité résonnante 103 du photodétecteur PD de l'un des autres pixels PIX du capteur d'images 700 (par exemple la couche isolante 601 de la cavité 103 du pixel PIX de gauche, dans l'orientation de la figure 7). Ainsi, à la différence des capteurs d'images 100, 200, 300, 400, 500 et 600 précédemment décrits en relation avec les figures 1 à 6, le capteur d'images 700 de la figure 7 comprend au moins une cavité résonnante 103 présentant une hauteur, ou épaisseur, différente de celles des autres cavités 103.

La présence de cavités résonnantes 103 d'épaisseurs différentes permet au capteur d'images 700 d'accéder à une bande spectrale plus large que celle qui serait obtenue au moyen de cavités résonnantes 103 ne différant que par les facteurs de remplissage de leurs structures diffractives 111. En outre, la présence des structures diffractives 111 présentant des facteurs de remplissage différents permet au capteur d'images 700 de présenter une résolution spectrale supérieure à celle qui serait obtenue au moyen d'un filtre ne comportant que des cavités résonnantes 103 d'épaisseurs différentes, par exemple en raison de limites inhérentes aux procédés de réalisation de cavités d'épaisseurs variables.

Ainsi, le fait de combiner, dans le capteur d'images 700, des cavités résonnantes 103 d'épaisseurs différentes et, à l'intérieur des cavités, des structures diffractives 111 présentant des facteurs de remplissage différents permet d'accéder à une bande spectrale plus étendue ou à une résolution supérieure à celle d'un capteur d'images ne présentant que l'une ou l'autre de ces caractéristiques.

La figure 8 est une vue de côté et en coupe, schématique et partielle, d'un exemple de capteur d'images 800 selon un mode de réalisation.

Le capteur d'images 800 de la figure 8 comprend des éléments en commun avec le capteur d'images 100 de la figure 1. Ces éléments communs ne seront pas détaillés à nouveau ci-après.

Le capteur d'images 800 de la figure 8 diffère du capteur d'images 100 de la figure 1 en ce que chaque cavité résonnante 103 du capteur d'images 800 de la figure 8 comprend une autre structure diffractive 801 interposée entre les première et deuxième couches miroir 105 et 107. Dans l'exemple représenté, chaque cavité résonnante 103 comprend en outre une couche isolante 803 interposée entre les structures diffractives 111 et 801. À titre de variante, la couche 803 est omise. Dans l'exemple illustré, la couche isolante 803 est située sur et en contact, par sa face inférieure, avec la face supérieure de la structure diffractive 111. En outre, dans cet exemple, la couche isolante 803 est située sous et en contact, par sa face supérieure, avec la face inférieure de la structure diffractive 801. Dans l'exemple représenté, la structure diffractive 801 est située sous et en contact, par sa face supérieure, avec la face inférieure de la deuxième couche miroir 107. Dans l'exemple illustré, la couche isolante 803 présente une épaisseur sensiblement constante. La couche isolante 803 est une couche transparente au rayonnement d'intérêt du capteur d'images 800. À titre d'exemple, la couche isolante 803 est en un oxyde, par exemple l'oxyde de silicium.

À titre d'exemple, la structure diffractive 801 est analogue ou identique à la structure diffractive 111. Dans le cas où les structures diffractives 801 et 111 sont identiques, aux dispersions de fabrication près, cela permet par exemple d'augmenter l'épaisseur du capteur d'images 800. À titre de variante, la structure diffractive 801 est différente de la structure diffractive 111. Cela procure par exemple alors une plus grande liberté de conception et de réalisation du capteur d'images 800.

Le capteur d'images 800 présente par exemple, du fait qu'il comprend la structure diffractive 801, une résolution spatiale supérieure à celle du capteur d'images 100.

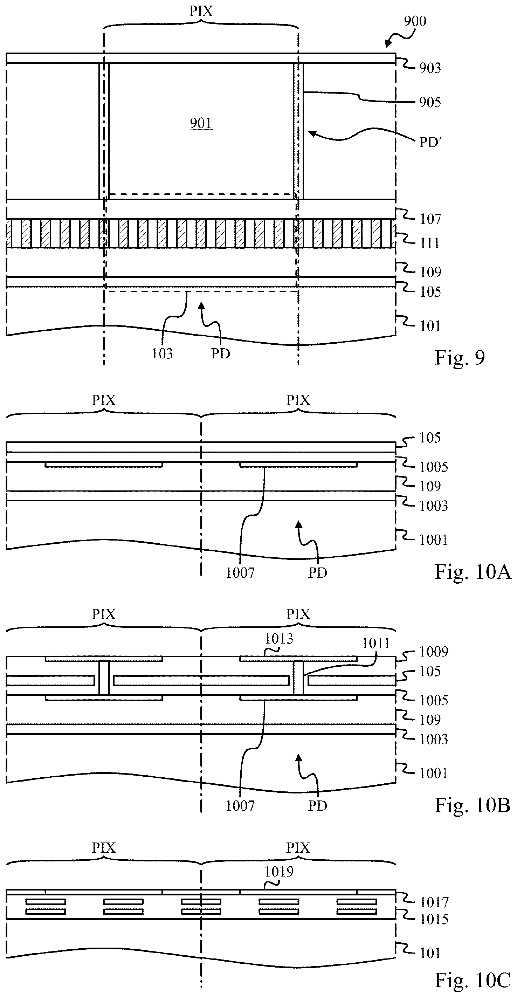

La figure 9 est une vue de côté et en coupe, schématique et partielle, d'un exemple de capteur d'images 900 selon un mode de réalisation.

Le capteur d'images 900 de la figure 9 comprend des éléments en commun avec le capteur d'images 100 de la figure 1. Ces éléments communs ne seront pas détaillés à nouveau ci-après.

Le capteur d'images 900 de la figure 9 diffère du capteur d'images 100 de la figure 1 en ce que chaque pixel PIX du capteur d'images 900 de la figure 9 comporte en outre un autre photodétecteur PD' situé sur et à l'aplomb du photodétecteur PD formé dans la cavité résonnante 103. Le photodétecteur PD' est par exemple sensible dans une plage de longueurs d'onde différente de la plage de sensibilité du photodétecteur PD. Le photodétecteur PD' est par exemple un photodétecteur visible, c'est-à-dire destiné à capter de la lumière visible et à convertir cette lumière en paires électron-trou. Dans l'exemple représenté, la deuxième couche miroir 107 est par exemple une couche en un oxyde, par exemple l'oxyde de silicium, interposée entre les photodétecteurs PD et PD'. À titre d'exemple, la deuxième couche miroir 107 est réalisée lors d'une étape de report, par exemple par collage moléculaire, des photodétecteurs PD' visibles sur les photodétecteurs PD.

Dans l'exemple illustré, chaque photodétecteur visible PD' comprend une couche de photoconversion 901, aussi appelée couche active ou couche photosensible, interposée entre la deuxième couche miroir 107 et une couche isolante 903. Dans cet exemple, la couche de photoconversion 901 est située sur et en contact, par sa face inférieure, avec la face supérieure de la deuxième couche miroir 107 et sous et en contact, par sa face supérieure, avec la face inférieure de la couche isolante 903. La couche isolante 903 est une couche transparente au rayonnement d'intérêt du capteur d'images 900. À titre d'exemple, la couche isolante 903 est en un oxyde, par exemple l'oxyde de silicium. La couche isolante 903 peut présenter une structure monocouche ou multicouche, par exemple une structure comprenant un empilement de couches en des matériaux isolants choisis parmi l'oxyde de silicium, le nitrure de silicium, l'oxynitrure de silicium, etc. La couche isolante 903 a par exemple pour fonction de passiver le capteur.

Dans l'exemple représenté, la couche de photoconversion 901 de chaque photodétecteur visible PD' est bordée latéralement par une tranchée d'isolation 905. Dans cet exemple, la tranchée d'isolation 905 revêt les flancs de la couche de photoconversion 901. La tranchée d'isolation 905 est par exemple plus précisément située sur et en contact avec tous les flancs de la couche de photoconversion 901.

Bien que cela n'ait pas été illustré en figure 9, le capteur d'images 900 peut en outre comprendre des filtres colorés et des microlentilles revêtant la face supérieure de la couche isolante 903. Dans ce cas, les filtres colorés du capteur d'images 900 sont par exemple des filtres rouge, vert et bleu arrangés sous forme de matrice, par exemple une matrice de Bayer.

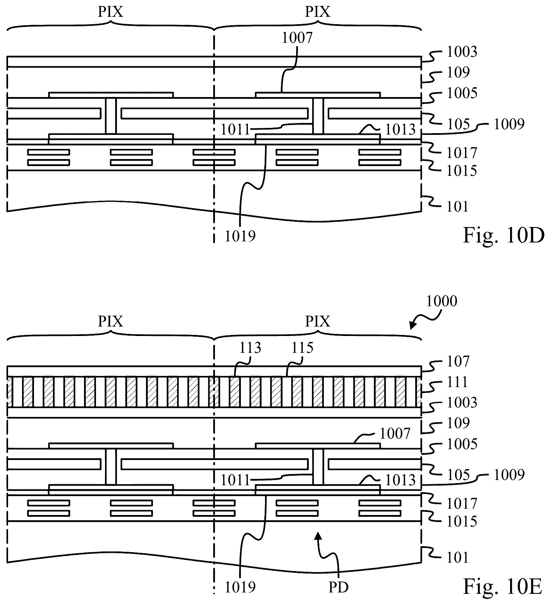

La figure 10A, la figure 10B, la figure 10C, la figure 10D et la figure 10E illustrent, par des vues de côté et en coupe, schématiques et partielles, des structures obtenues à l'issue d'étapes successives d'un procédé de fabrication d'un capteur d'images 1000 selon un mode de réalisation. Le capteur d'images 1000 comprend des éléments en commun avec le capteur d'images 100 de la figure 1. Ces éléments communs ne seront pas détaillés à nouveau ci-après.

À des fins de simplification, seuls deux pixels PIX comprenant chacun un seul photodétecteur PD ont été illustrés en figures 10A à 10E étant entendu que le capteur d'images 1000 peut, à titre de variante, comprendre un nombre plus important de pixels PIX et que chaque pixel PIX peut comprendre plusieurs photodétecteurs PD.

La figure 10A illustre une structure obtenue à l'issue d'une étape de formation, sur un substrat de support temporaire 1001, ou poignée, d'un empilement comprenant, dans cet ordre depuis la face supérieure du substrat de support temporaire 1001, une couche isolante 1003, la couche de photoconversion 109, une couche isolante 1005 et la première couche miroir 105.

Dans l'exemple représenté, chaque photodétecteur PD comprend une région 1007 dopée permettant de réaliser une jonction semiconductrice au sein de la couche 109, permettant ainsi d'extraire les charges photogénérées. La région dopée 1007 s'étend dans la couche de photoconversion 109 depuis la face supérieure de la couche 109 jusqu'à une profondeur inférieure à l'épaisseur de la couche 109. À titre d'exemple, la région conductrice 1007 correspond à une zone de la couche de photoconversion 109 présentant un niveau de dopage strictement supérieur, par exemple au moins dix, cent ou mille fois supérieur, à celui du reste de la couche de photoconversion 109. La région dopée 1007 fait par exemple office d'électrode inférieure du photodétecteur PD et est isolée des régions dopées 1007 des autres photodétecteurs PD du capteur d'images 1000.

Bien que cela n'ait pas été illustré en figure 10A afin de ne pas surcharger le dessin, une partie de la couche de photoconversion 109 située sur et en contact avec la couche isolante 1003 sous-jacente peut, pour chaque photodétecteur PD du capteur d'images 1000, être dopée de manière à former une autre électrode du photodétecteur 1000. À la différence des régions dopées 1007, cette électrode peut être commune à plusieurs photodétecteurs PD, voire à tous les photodétecteurs PD, du capteur d'images 1000.

La figure 10B illustre une structure obtenue à l'issue d'une étape ultérieure de dépôt d'une couche isolante 1009 sur la face supérieure de la structure de la figure 10A, d'ouverture de la couche isolante 1009 et de la couche miroir 105 à l'aplomb des régions dopées 1007, de formation de vias conducteurs 1011 dans les ouvertures et de réalisation d'éléments de reprise de contact 1013 dans la couche isolante 1009.

La couche isolante 1009 revêt la couche miroir 105. Dans l'exemple représenté, la couche isolante 1009 est plus précisément située sur et en contact avec la couche miroir 105. À titre d'exemple, la couche isolante 1009 est en un oxyde, par exemple l'oxyde de silicium.

Dans l'exemple illustré, les éléments de reprise de contact 1013 s'étendent dans la couche isolante 1009 depuis la face supérieure de la couche 1009 jusqu'à une profondeur inférieure à l'épaisseur de la couche 1009. Chaque élément de reprise de contact 1013 est par exemple situé à l'aplomb d'une région dopée 1007. À titre d'exemple, les éléments de reprise de contact 1013 sont en un métal ou en un alliage métallique. Les éléments de reprise de contact 1013 sont par exemple réalisés par la mise en œuvre d'un procédé de type « damascène ».

Dans l'exemple représenté, chaque via conducteur 1011 s'étend, depuis la face inférieure de l'un des éléments de reprise de contact 1013 , à travers la couche isolante 1009, la couche miroir 105 et la couche isolante 1005, jusqu'à la face supérieure de la région dopée 1007 sous-jacente. À titre d'exemple, chaque via conducteur 1011 présente une région centrale conductrice dont les flancs sont revêtus d'une région isolante, par exemple en un oxyde, par exemple l'oxyde de silicium. Cela permet notamment d'isoler la région centrale du via 1011 par rapport à la couche miroir 105. En pratique, des premiers trous sont par exemple formés dans la couche 105 puis remplis d'oxyde et des deuxièmes trous présentant des dimensions latérales inférieures aux premiers trous sont ensuite formés dans l'oxyde.

La figure 10C illustre une structure obtenue à l'issue d'une étape de formation, sur le substrat semiconducteur 101, d'un empilement d'interconnexion 1015 et d'une couche isolante 1017 dans laquelle sont formés des éléments de reprise de contact 1019. La structure représentée en figure 10C peut indifféremment être réalisée avant, pendant ou après la structure précédemment décrite en relation avec les figures 10A et 10B.

À titre d'exemple, le substrat semiconducteur 101 est de type CMOS (de l'anglais « Complementary Metal-Oxide-Semiconductor » - métal-oxyde-semiconducteur complémentaire) et comprend des transistors CMOS de commande des pixels PIX du capteur d'images 1000.

L'empilement d'interconnexion 1015 revêt par exemple la face supérieure du substrat semiconducteur 101. Dans l'exemple représenté, l'empilement d'interconnexion 1015 est plus précisément situé sur et en contact avec la face supérieure du substrat semiconducteur 101. À titre d'exemple, l'empilement d'interconnexion 1015 comprend des couches conductrices, par exemple des couches métalliques aussi appelées niveaux de métallisation, et des couches isolantes alternées. L'empilement d'interconnexion 1015 permet par exemple de connecter les éléments de reprise de contact 1019 aux transistors formés dans le substrat semiconducteur 101.

Dans l'exemple représenté, la couche isolante 1017 revêt la face supérieure de l'empilement d'interconnexion 1015. À titre de variante, la couche isolante 1017 peut faire partie de l'empilement d'interconnexion 1015.

Dans l'exemple illustré, les éléments de reprise de contact 1019 présentent chacun une hauteur sensiblement égale à l'épaisseur de la couche isolante 1017. Chaque élément de reprise de contact 1019 est par exemple destiné à être mis en contact avec l'un des éléments de reprise de contact 1013. À titre d'exemple, les éléments de reprise de contact 1019 sont en un métal ou en un alliage métallique. Les éléments de reprise de contact 1019 sont par exemple réalisés par la mise en œuvre d'un procédé de type « damascène ».

La figure 10D illustre une structure obtenue à l'issue d'une étape ultérieure de report de la structure de la figure 10B sur la structure de la figure 10C et de retrait du substrat de support temporaire 1001.

La structure de la figure 10B est par exemple retournée puis mise en contact, par des faces de la couche isolante 1009 et des éléments de reprise de contact 1013 opposées au substrat de support temporaire 1001 (les faces inférieures de la couche isolante 1009 et des éléments de reprise de contact 1013, dans l'orientation de la figure 10D), avec les faces supérieures de la couche isolante 1017 et des éléments de reprise de contact 1019 de la structure de la figure 10C, respectivement. À titre d'exemple, les structures sont solidarisées mécaniquement, c'est-à-dire fixées mécaniquement l'une à l'autre, par collage des surfaces en contact. Le collage est par exemple un collage de type direct, par exemple un collage moléculaire. Dans le cas où les régions isolantes 1009 et 1017 sont en oxyde et où les éléments de reprise de contact 1013 et 1019 sont métalliques, le collage moléculaire est dit « hybride ».

Le retrait du substrat de support temporaire 1001 est par exemple effectué par polissage mécano-chimique (« Chemical and Mechanical Polishing » - CMP, en anglais). Dans l'exemple représenté, le substrat de support temporaire 1001 est intégralement retiré à l'issue de cette étape.

À l'issue de cette étape, les régions dopées 1007 sont par exemple connectées aux transistors de commande des pixels PIX formés dans le substrat semiconducteur 101.

La figure 10E illustre une structure obtenue à l'issue d'une étape ultérieure de formation des structures diffractives 111 puis de la deuxième couche miroir 107 du côté de la face supérieure de la structure de la figure 10D.

Les structures diffractives 111 sont par exemple réalisées par dépôt d'une première couche en le premier matériau des premières régions 113 suivie d'une étape de photolithographie puis gravure de la première couche de sorte à former des ouvertures traversantes dans la première couche. Les ouvertures formées dans la première couche sont par exemple ensuite comblées par le dépôt d'une deuxième couche en le deuxième matériau de la ou des deuxièmes régions 115. Une opération de polissage mécano-chimique peut être mise en œuvre postérieurement au dépôt de la deuxième couche de sorte que la face supérieure de chaque structure diffractive 111 présente une surface sensiblement plane.

La couche miroir 107 est par exemple ensuite déposée sur la structure diffractive 111.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, la personne du métier est capable d'effectuer des combinaisons entre les modes de réalisation des figures 1 à 9 et 10E. Par ailleurs, la personne du métier est capable d'adapter le procédé décrit en relation avec les figures 10A à 10E pour réaliser les capteurs d'images précédemment décrits en relation avec les figures 2 à 9 à partir des indications de la présente description.

Enfin, la mise en œuvre pratique des modes de réalisation et variantes décrits est à la portée de la personne du métier à partir des indications fonctionnelles données ci-dessus. En particulier, les modes de réalisation décrits ne se limitent pas aux exemples particuliers de matériaux et de dimensions mentionnés dans la présente description.

## Revendications

1. Capteur d'images (100 ; 200 ; 300 ; 400 ; 500 ; 600 ; 700 ; 800 ; 900 ; 1000) comprenant une pluralité de pixels (PIX) formés dans et sur un substrat semiconducteur (101) et comportant chacun au moins un photodétecteur (PD) comprenant une cavité résonnante (103) comportant, entre des première (105) et deuxième (107) couches miroir, une couche de photoconversion (109) et au moins une structure diffractive (111).

2. Capteur (100 ; 200 ; 300 ; 400 ; 500 ; 600 ; 700 ; 800 ; 900 ; 1000) selon la revendication 1, dans lequel chaque structure diffractive (111) comprend une pluralité de premières régions (113) en un premier matériau présentant un premier indice de réfraction séparées les unes des autres par au moins une deuxième région (115) en un deuxième matériau présentant un deuxième indice de réfraction inférieur au premier indice de réfraction.

3. Capteur (100 ; 200 ; 300 ; 400 ; 500 ; 600 ; 700 ; 800 ; 900 ; 1000) selon la revendication 2, dans lequel les premier et deuxième matériaux présentent une même composition chimique et des structures différentes.

4. Capteur (100 ; 500 ; 600 ; 700 ; 800 ; 900 ; 1000) selon la revendication 2 ou 3, dans lequel les structures diffractives (111) des cavités résonnantes (103) des photodétecteurs (PD) présentent un même facteur de remplissage.

5. Capteur (200 ; 300 ; 400) selon la revendication 2 ou 3, dans lequel ladite au moins une structure diffractive (111) de la cavité résonnante (103) de l'un des photodétecteurs (PD) présente un facteur de remplissage différent de celui de ladite au moins une structure diffractive (111) de la cavité résonnante (103) d'un autre photodétecteur (PD).

6. Capteur (300) selon la revendication 5, dans lequel les premières régions (113) de ladite au moins une structure diffractive (111) de la cavité résonnante (103) de l'un des photodétecteurs (PD) forment un réseau présentant un pas différent de celui d'un réseau formé par les premières régions (113) de ladite au moins une structure diffractive (111) de la cavité résonnante (103) d'un autre photodétecteur (PD).

7. Capteur (200 ; 300) selon la revendication 5 ou 6, dans lequel les premières régions (113) de ladite au moins une structure diffractive (111) de la cavité résonnante (103) de l'un des photodétecteurs (PD) présentent des dimensions latérales différentes de celles des premières régions (113) de ladite au moins une structure diffractive (111) de la cavité résonnante (103) d'un autre photodétecteur (PD).

8. Capteur (400) selon l'une quelconque des revendications 4 à 7, dans lequel, à l'intérieur d'une même structure diffractive (111), l'une des premières régions (113) présente des dimensions latérales différentes de celles d'une autre première région (113).

9. Capteur (100 ; 200 ; 300 ; 400 ; 500 ; 600 ; 700 ; 800 ; 900 ; 1000) selon l'une quelconque des revendications 3 à 8, dans lequel chaque première région (113) est un plot.

10. Capteur (100 ; 200 ; 300 ; 400 ; 500 ; 600 ; 700 ; 800 ; 900 ; 1000) selon l'une quelconque des revendications 3 à 8, dans lequel chaque première région (113) est une bande s'étendant latéralement entre deux flancs opposés de la structure diffractive (111).

11. Capteur (100 ; 200 ; 300 ; 400 ; 500 ; 600 ; 700 ; 800 ; 900 ; 1000) selon l'une quelconque des revendications 3 à 8, dans lequel les premières régions (113) forment une grille et les deuxièmes régions (115) forment des plots situés dans des cases de la grille.

12. Capteur (100 ; 200 ; 300 ; 400 ; 500 ; 600 ; 700 ; 800 ; 900 ; 1000) selon l'une quelconque des revendications 1 à 11, dans lequel au moins l'une des cavités résonnantes (103) présente une épaisseur différente de celle d'une autre cavité résonnante (103).

13. Capteur (100 ; 200 ; 300 ; 400 ; 500 ; 600 ; 700 ; 800 ; 900 ; 1000) selon l'une quelconque des revendications 1 à 12, dans lequel la cavité résonnante (103) est constituée d'un empilement comprenant, dans l'ordre depuis une face supérieure du substrat semiconducteur (101), la première couche miroir (105), la couche de photoconversion (109), la structure diffractive (111) et la deuxième couche miroir (107).

14. Capteur (600 ; 700) selon l'une quelconque des revendications 1 à 13, dans lequel chaque cavité résonnante (103) comprend en outre au moins une première couche isolante (601) interposée entre ladite au moins une structure diffractive (111) et la deuxième couche miroir (107).

15. Capteur (500) selon l'une quelconque des revendications 1 à 14, dans lequel chaque cavité résonnante (103) comprend en outre au moins une deuxième couche isolante (501) interposée entre la couche de photoconversion (109) et ladite au moins une structure diffractive (111).

16. Capteur (100 ; 200 ; 300 ; 400 ; 500 ; 600 ; 700 ; 800 ; 900 ; 1000) selon l'une quelconque des revendications 1 à 15, dans lequel ledit au moins un photodétecteur (PD) est un photodétecteur infrarouge, de préférence un photodétecteur infrarouge proche.

17. Capteur (100 ; 200 ; 300 ; 400 ; 500 ; 600 ; 700 ; 800 ; 900 ; 1000) selon l'une quelconque des revendications 1 à 16, dans lequel chaque pixel (PIX) comprend en outre, superposé audit au moins un photodétecteur (PD), un photodétecteur visible (PD').
